# EUROPÄISCHE PATENTSCHRIFT

(11) **EP 1 254 506 B1**
(45) Veröffentlichungstag und Bekanntmachung des Hinweises auf die Patenterteilung: **27.09.2006**
(21) Anmeldenummer: 00987416.5
(22) Anmeldetag: 19.12.2000
(51) Int. Cl.: H02P 1/28

(54) **SCHALTUNGSANORDNUNG**
CIRCUIT ARRANGEMENT
CIRCUITERIE

(30) Priorität: 10.02.2000 DE 20002336 U
(43) Veröffentlichungstag der Anmeldung: 06.11.2002
(73) Patentinhaber: Moeller GmbH, 53115 Bonn (DE)
(72) Erfinder: MAGYAR, Peter, 33813 Oerlinghausen (DE); GÜNZEL, Rainer, 53639 Königswinter (DE)
(86) Internationale Anmeldenummer: PCT/EP2000/012942
(87) Internationale Veröffentlichungsnummer: WO 2001/059920

(56) Entgegenhaltungen:
- EP-A- 0 070 633
- EP-A- 0 766 506
- DE-A- 3 031 287
- DE-A- 4 310 043
- DE-A- 19 716 113
- US-A- 3 708 609

## Beschreibung

Die Erfindung betrifft eine Schaltungsanordnung, insbesondere eine konstruktive Ausführung für Halbleiterwendeschütze oder Halbleitersanftstarter oder dergleichen.

Bekannte Schaltungsanordnungen sind aufgrund ihrer Bauteilanordnungen mit mehreren Leitungskreuzungen ausgebildet. Ein typisches Beispiel einer solchen Schaltungsanordnung findet sich in EP 0070633 A.

Um die Leitungskreuzungen fertigen zu können, werden die Schaltungen entweder mit mehrlagigen Leiterplatten, mit mehrlagigen laminierten Leiterbahnkonstruktionen (Bus-Bar-Technik) oder durch aufwendige Handarbeit unter Verwendung von Stanzbiegeteilen realisiert. Mehrlagige Leiterplatten sind aber nur für geringere Bemessungsströme geeignet und die Fertigung mit Handarbeitsvorgängen ist schwer in einen Automatisierungsprozess einbindbar. Insbesondere die Bus-Bar-Technik, aber auch die Fertigung mit mehrlagigen Leiterplatten ist darüber hinaus sehr teuer.

Der Erfindung liegt daher die Aufgabe zugrunde, eine Leiterbahnstruktur einer Schaltungsanordnung bereitzustellen, die in ihrem Aufbau einfach und somit auch preiswert herstellbar ist.

Die Lösung der Aufgabe gemäß Anspruch 1 besteht im Kern darin, dass die vier Halbleiter eine Ringstruktur bildend in Serie geschaltet sind, wobei die vier Verbindungspunkte zwischen den einzelnen Halbleitern abwechselnd für Ein- und Ausgänge die Abgriffspunkte bilden derart, dass lediglich eine Leitungskreuzung erfolgt.

Den abhängigen Ansprüchen sind vorteilhafte Weiterbildungen der Erfindung zu entnehmen.

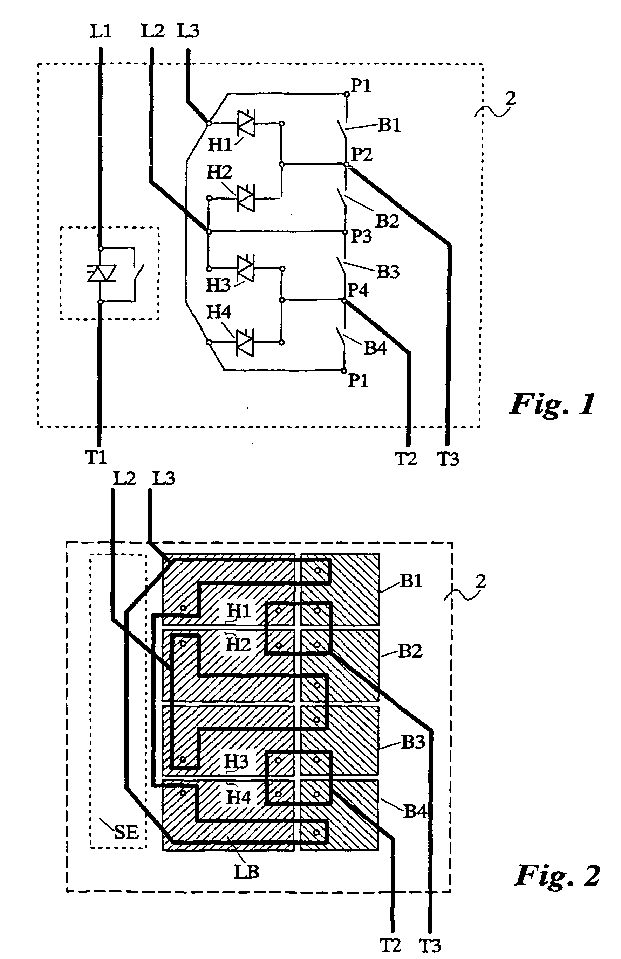

Durch die erfindungsgemäße Anordnung und Verschaltung von Bauteilen und Anschlüssen wird die Anzahl der Leitungskreuzungen minimiert und der Herstellungsaufwand der Schaltungsanordnung reduziert. In einer bevorzugten Ausführung der Erfindung sind die Eingänge der Schaltungsanordnung im Bereich einer ersten Stirnseite und die Ausgänge der Schaltungsanordnung im Bereich der gegenüberüegenden Stirnseite der Leiterplatte angeordnet. Ferner sind mit Vorteil die serienartig hintereinander geschalteten und zu einer Ringstruktur miteinander verbundenen Halbleiter derart angeordnet und miteinander verbunden, dass ein mäandrischer Leitungsstrang gebildet wird. Dabei ist vorzugsweise jedem der Halbleiter ein Bypasskontakt parallelgeschaltet, der bei leitendem Halbleiter, geschlossen wird und so den Halbleiter entlastet, so dass dieser eine geringere Verlustleistung produziert. Mit Vorteil sind die Bypasskontakte gemäß Fig. 1 im wesentlichen geradlinig hintereinaridergeschaltet angeordnet. Durch die bevorzugte Anordnung von Halbleitern und Bypasskontakten kann eine weniger aufwendige Herstellung gewährleistet und eine kompakte Bauform realisiert werden.

Weitere Einzelheiten und Vorteile der Erfindung ergeben sich aus dem folgenden, anhand von Figuren erläuterten Ausführungsbeispiel. Es zeigen
- Figur 1:: die erfindungsgemäße Schaltungsanordnung für eine Layoutanordnung in einer bevorzugten Ausführungsform; und
- Figur 2:: ein mögliches Layout für die Schaltungsanordnung gemäß Fig. 1.

Fig. 1 zeigt eine bevorzugte Ausführungsform der erfindungsgemäßen Schaltungsanordnung. Die Schaltungsanordnung ist insbesondere für Halbleiterschütze oder Halbleitersanftanlaufgeräte mit Wendefunktion zur Steuerung dreiphasiger Drehstrommotoren vorgesehen. Sie umfaßt eine Leiterplatte 2 mit mindestens zwei Eingängen L2, L3, mit mindestens zwei Ausgängen T2, T3 und mit mindestens vier steuerbaren, bidirektional leitfähigen Halbleitern H1, H2, H3, H4. Dabei sind die Anschlüsse für Ein- und Ausgänge L2, L3; T2, T3 um einen standardisierten Anschluß zu gewährleisten außerhalb der Leiterbahnstruktur jeweils paarweise nebeneinander angeordnet. Außerhalb der Leiterbahnstruktur heißt, dass Eingänge L2, L3 und Ausgänge T2, T3 die auf der Leiterplatte 2 am außenliegendsten Punkte der Leiterbahnstruktur bilden derart, dass von diesen Punkten aus ohne weitere Leitungsbahnquerung Leitungsverbindungen in zumindest eine Richtung auf der Leiterplatte möglich sind. Die vier Halbleiter H1, H2, H3, H4 sind, eine Ringstruktur bildend, in Serie geschaltet. Die vier Verbindungspunkte P1, P2, P3, P4 zwischen den einzelnen Halbleitern H1, H2, H3, H4 bilden die Abgriffspunkte für die Ein- und Ausgänge L2, L3; T2, T3. Dabei bilden die Verbindungspunkte P1, P2, P3, P4, ausgehend vom ersten Verbindungspunkt P1, abwechselnd jeweils einen Eingang oder einen Ausgang: durch den Verbindungspunkt P1 wird der Eingang L3 gebildet, der nächste Verbindungspunkt P2 bildet den zugehörigen Ausgang T3, P3 bildet L2 und P4 bildet T2. Desweiteren ist neben den beiden Phasenzweigen L2-T2 und L3-T3 ein dritter Phasenzweig L1-T1 vorgesehen. Da die Schaltungsanordnung für eine Wendefunktion (zur Drehrichtungsumkehr eines Drehstrommotors) konzipiert ist, sind zumindest zwei der drei Phasenzweige (hier L2-T2 und L3-T3) steuerbar, das heißt mit einem steuerbaren und bipolar leitfähigen Halbleiter ausgeführt. Der dritte Phasenzweig kann hier wahlweise steuerbar oder nicht steuerbar, das heißt mit oder ohne Halbleiter, ausgebildet sein. Auch kann der dritte Phasenzweig L1-T1 wahlweise Bestandteil der Schaltungsanordnung, also auf der Leiterplatte befindlich, sein oder separat ausgeführt werden.

Wie in Figur 1 dargestellt, ist jedem Halbleiter H1, H2, H3, H4 ein Bypasskontakt B1, B2, B3, B4 parallelgeschaltet. Dieser soll bei durchgeschaltetetem Halbleiter diesen zur Verminderung der Verlustleistung jeweils überbrücken. Die netzseitigen Eingänge L1, L2, L3 und die lastseitigen zugehörigen Ausgänge T1, T2, T3 sind wie in Figur 1 gezeigt jeweils gegenüberliegend ausgeführt. Die Leiterplatte ist mit Vorteil einlagig ausgebildet, wobei die einzige Leitungsquerung (Anschlußleitung für Eingang L2) beispielweise dadurch realisiert wird, daß die Anschlußleitung zu L2 als ein Stanzbiegeteil ausgeführt und mit dem Verbindungspunkt P3 gelötet, genietet oder ähnlicherweise elektrisch und mechanisch verbunden ist. Eine besonders bevorzugte Ausführung ergibt sich dadurch, daß die elektrischen Leitungsverbindungen LB aus laminierten Kupferplatten ausgeführt sind und aufgrund der Bus-Bar-Technik eine kompakte mechanische Träger- und elektrische Verbindungseinheit bilden. Die laminierte Bus-Bar-Einheit ist eine ein- oder mehrlagige "Leiterplatte" für höhere Ströme, wo die Leiterbahnen als Kupferverbindungen ausgeführt und durch Isolationsmaterial voneinander getrennt sind. Das so entstehende Gebilde ist mechanisch selbstragend; auf die Isolier- und Trägerfunktion dienende "Platte" der herkömmlichen Leiterplatten kann also verzichtet werden.

Ferner sind die Halbleiter H1, H2, H3, H4 und die Bypasskontakte B1, B2, B3, B4 vorzugsweise als acht einzelne Module ausgebildet, wobei die vier Einzelmodule der Halbleiter H1, H2, H3, H4 auf einem gemeinsamen Kühlkörper angeordnet sind. Um die Schaltungsanordnung in möglichst kompakter Bauweise realisieren zu können sind die Halbleiter vorzugsweise im wesentlichen parallel neben- oder übereinander angeordnet und über Leitungsabschnitte zu einen mäandrischen Leitungsstrang verbunden, der an seinen Enden über einen weiteren Leitungsabschnitt zu einer Ringstruktur geschlossen wird. Neben dem mäandrischen Leitungsstrang der Halbleiter H1, H2, H3, H4 sind die Bypasskontakte B1, B2, B3, B4 zu einem im wesentlichen geradlinig verlaufenden Leitungsstrang angeordnet.

Figur 2 zeigt die mögliche Ausführung eines Layouts für die Schaltungsanordnung mit dem Aufbau gemäß Figur 1. Hierbei trägt die Leiterplatte 2 noch eine Steuereinrichtung SE (Startersteuerung, Umkehrlogik, Bypasssteuerung, Stromversorgung,...) zur Ansteuerung der Halbleiter H1, H2, H3, H4 und der Bypasskontakte B1, B2, B3, B4.

## Patentansprüche

1. Schaltungsanordnung, insbesondere für Halbleiterwendeschütz, umfassend eine Leiterplatte (2) mit folgender Leiterbahnstruktur:
- mindestens zwei Eingängen (L2, L3),
- mindestens zwei Ausgängen (T2, T3),
- mindestens vier steuerbaren, bidirektional leitfähigen Halbleitern (H1, H2, H3, H4);
wobei die Eingänge (L2, L3) und die Ausgänge (T2, T3) außerhalb der Leiterbahnstruktur, jeweils paarweise nebeneinander angeordnet sind,
wobei die Leiterbahnstruktur in der Weise ausgebildet sind, dass die vier Halbleiter (H1, H2, H3, H4) eine Ringstruktur bildend in Serie geschaltet sind, und die vier Verbindungspunkte (P1, P2, P3, P4) zwischen den einzelnen Halbleitern (H1, H2, H3, H4) abwechselnd für Ein- und Ausgänge (L3, T3, L2, T2) die Abgriffspunkte bilden derart, dass lediglich eine Leitungskreuzung erfolgt.

2. Schaltungsanordnung nach Anspruch 1, **dadurch gekennzeichnet, dass** jedem Halbleiter (H1, H2, H3, H4) ein Bypasskontakt (B1, B2, B3, B4) parallelgeschaltet ist.

3. Schaltungsanordnung nach Anspruch 1 oder 2, **dadurch gekennzeichnet, dass** Ein- und Ausgänge (L2, L3; T2, T3) gegenüberliegend angeordnet sind.

4. Schaltungsanordnung nach einem der vorherigen Ansprüche, **dadurch gekennzeichnet, dass** die Leiterplatte (2) einlagig ausgebildet ist.

5. Schaltungsanordnung nach einem der Ansprüche 1-3, **dadurch gekennzeichnet, dass** die Leiterbahnverbindungen einschliesslich der Ein- und Ausgänge (L2,L3,T2,T3) als zweilagige lamininierte Bus-Bar-Platte ausgebildet sind.

6. Schaltungsanordnung nach einem der vorherigen Ansprüche, **dadurch gekennzeichnet, dass** alle Halbleiter (H1, H2, H3, H4) in thermisch leitender Verbindung auf einem gemeinsamen Kühlkörper montiert sind.

7. Schaltungsanordnung nach einem der vorherigen Ansprüche, **dadurch gekennzeichnet, dass** die Halbleiter (H1, H2, H3, H4) einen mäanderartig ausgebildeten Leitungsstrang bilden.

8. Schaltungsanordnung nach einem der Ansprüche 2-7, **dadurch gekennzeichnet, dass** die Bypasskontakte (B1, B2, B3, B4) als geradlinig ausgebildeter Leitungsstrang ausgebildet sind.

9. Schaltungsanordnung nach einem der vorherigen Ansprüche, **dadurch gekennzeichnet, dass** die Halbleiter (H1, H2, H3, H4) übereinander, nebeneinander oder in einer rechteckigen Geometrie angeordnet sind.

## Claims

1. Circuit arrangement, in particular for a semiconductor reversing contactor, comprising a printed circuit board (2) with the following conductor track structure:
- at least two inputs (L2, L3),
- at least two outputs (T2, T3),
- at least four controllable, bidirectionally conductive semiconductors (H1, H2, H3, H4);
wherein the inputs (L2, L3) and the outputs (T2, T3) are each positioned adjacently in pairs outside the conductor track structure,
wherein the conductor track structure is configured such that the four semiconductors (H1, H2, H3, H4) are connected in series, forming a ring structure, and the four connection points (P1, P2, P3, P4) between the individual semiconductors (H1, H2, H3, H4) alternately form tapping points for inputs and outputs (L3, T3, L2, T2), such that there results only one line crossing.

2. Circuit arrangement according to claim 1, **characterised in that** a bypass contact (B1, B2, B3, B4) is connected in parallel with each semiconductor (H1, H2, H3, H4).

3. Circuit arrangement according to either claim 1 or claim 2, **characterised in that** inputs and outputs (L2, L3; T2, T3) are positioned opposite one another.

4. Circuit arrangement according to any one of the preceding claims, **characterised in that** the printed circuit board (2) is configured in a single layer.

5. Circuit arrangement according to any one of claims 1 to 3, **characterised in that** the conductor track connections including the inputs and outputs (L2, L3, T2, T3) are configured as a two-layer laminated bus bar plate.

6. Circuit arrangement according to any one of the preceding claims, **characterised in that** all the semiconductors (H1, H2, H3, H4) are assembled on a common cooling body in a thermally conducting connection.

7. Circuit arrangement according to any one of the preceding claims, **characterised in that** the semiconductors (H1, H2, H3, H4) form a line branch configured in a meander shape.

8. Circuit arrangement according to any one of the claims 2 to 7, **characterised in that** the bypass contacts (B1, B2, B3, B4) are configured as a straight line branch.

9. Circuit arrangement according to any one of the preceding claims, **characterised in that** the semiconductors (H1, H2, H3, H4) are positioned above one another, next to one another or in a rectangular geometric configuration.

## Revendications

1. Agencement de circuit, en particulier pour un contacteur inverseur à semiconducteur, comprenant une carte de circuit imprimé (2) présentant la structure de circuit suivante:
- au moins deux entrées (L2, L3),
- au moins deux sorties (T2, T3),
- au moins quatre semiconducteurs à conduction bidirectionnelle commandable (H1, H2, H3, H4);
dans lequel les entrées (L2, L3) et les sorties (T2, T3) sont respectivement agencées à l'extérieur de la structure de circuit en paires, côte à côte,
dans lequel la structure de circuit est formée de telle sorte que les quatre semiconducteurs (H1, H2, H3, H4) sont montés en série et forment une structure en anneau et les quatre points de connexion (P1, P2, P3, P4) entre les semiconducteurs individuels (H1, H2, H3, H4) forment alternativement des points d'extraction pour les entrées et sorties (L3, T3, L2, T2) de telle sorte qu'un unique croisement de lignes en résulte.

2. Agencement de circuit selon la revendication 1, **caractérisé en ce que** chaque semiconducteur (H1, H2, H3, H4) est monté en parallèle avec un commutateur de dérivation (B1, B2, B3, B4).

3. Agencement de circuit selon la revendication 1 ou 2, **caractérisé en ce que** les entrées et sorties (L2, L3, T2, T3) sont agencées de façon opposée.

4. Agencement de circuit selon l'une des revendications précédentes, **caractérisé en ce que** la carte de circuit imprimé (2) est agencée en monocouche.

5. Agencement de circuit selon l'une des revendications 1-3, **caractérisé en ce que** les liaisons de circuit y compris les entrées et sorties (L3, T3, L2, T2) sont agencées en plaque barre bus stratifiée en deux couches.

6. Agencement de circuit selon l'une des revendications précédentes, **caractérisé en ce que** tous les semiconducteurs (H1, H2, H3, H4) sont montés avec un dissipateur de chaleur commun qui est en relation de conduction thermique.

7. Agencement de circuit selon l'une des revendications précédentes, **caractérisé en ce que** les semiconducteurs (H1, H2, H3, H4) forment une voie conductrice configurée en méandre.

8. Agencement de circuit selon l'une des revendications 2-7, **caractérisé en ce que** les commutateurs de dérivation (B1, B2, B3, B4) sont configurées selon une voie conductrice rectiligne.

9. Agencement de circuit selon l'une des revendications précédentes, **caractérisé en ce que** les semiconducteurs (H1, H2, H3, H4) sont agencés l'un sur l'autre, côte à côte ou selon une géométrie rectangulaire.
